# EUROPEAN PATENT SPECIFICATION

(11) **EP 3 553 841 B1**
(45) Date of publication and mention of the grant of the patent: **16.02.2022**
(21) Application number: 18166677.7
(22) Date of filing: 10.04.2018
(51) Int. Cl.: H01L 51/42, C23C 16/40

(54) **METHOD OF MANUFACTURING A PEROVSKITE-BASED PHOTOVOLTAIC DEVICE**
VERFAHREN ZUR HERSTELLUNG EINER FOTOVOLTAISCHEN VORRICHTUNG AUF PEROVSKIT-BASIS
PROCÉDÉ DE FABRICATION D'UN DISPOSITIF PHOTOVOLTAÏQUE À BASE DE PÉROVSKITE

(43) Date of publication of application: 16.10.2019
(73) Proprietor: CSEM Centre Suisse d'Electronique et de Microtechnique SA, 2002 Neuchâtel (CH)
(72) Inventor: NICOLAY, Sylvain, 1568 Portalban (CH); KAMINO, Brett, 2502 Bienne (CH); WALTER, Arnaud, 2000 Neuchâtel (CH)
(74) Representative: e-Patent SA

(56) References cited:
- WO-A1-2016/144883
- WO-A1-2018/057419
- US-A1- 2015 380 667
- SAWANTA S. MALI AND CHANG KOOK HONG: "p-i-n/n-i-p type planar hybrid structure of highly efficient perovskite solar cells towards improved air stability: synthetic strategies and the role of p-type hole transport layer (HTL) and n-type electron transport layer (ETL) metal oxides", NANOSCALE, vol. 8, 2016, pages 10528-10540, XP002785227, DOI: 10.1039/c6nr02276f.
- JINGBI YOU ET AL.: "Improved air stability of perovskite solar cells via solution-processed metal oxide transport layers", NATURE NANOTECHNOLOGY, vol. 11, 12 October 2015 (2015-10-12), pages 75-81, XP002785228, DOI: 10.1038/NNANO.2015.230
- STEFAN WEBER, THOMAS RATHE, JIMMY MANGALAM, BIRGIT KUNERT, ANNA MARIA COCLITE, MARTIN BAUCH, THEODOROS DIMOPOULOS, GREGOR TRIMMEL: "Investigation of NiOx-hole transport layers in triple cation perovskite solar cells", JOURNAL OF MATERIALS SCIENCE: MATERIALS IN ELECTRONICS, vol. 29, 1 November 2017 (2017-11-01), pages 1847-1855, XP002785229, DOI: 10.1007/s10854-017-8094-9
- HOBEOM KIM, KYUNG-GEUN LIM, AND TAE-WOO LEE: "Planar heterojunction organometal halide perovskite solar cells: roles of interfacial layers", ENERGY & ENVIRONMENTAL SCIENCE, vol. 9, 13 October 2015 (2015-10-13), pages 12-30, XP002785230, DOI: 10.1039/C5EE02194D

## Description

### Technical Field

The present invention relates to the technical field of photovoltaic devices. More particularly, it relates to a method of manufacturing a perovskite-based photovoltaic device.

Such photovoltaic devices are commonly referred to as "solar cells" or "solar panels".

### State of the art

Recently, photovoltaic devices (PV devices) based on so-called Perovskite absorber layers have been showing promise as an alternative or complement to conventional crystalline and thin-film silicon-based PV devices. "Perovskites" are organometallic halide materials with a formula generically written as ABX₃, where A is an inorganic or organic cation such as Cs, CH₃NH₃ or HC(NH₂)₂, B is a metal such as tin or lead, and X is a halogen atom such as iodine, bromine or chlorine. Examples of such materials are methylammonium lead trihalide (CH₃NH₃PbX₃), Caesium formamidinum lead trihalide (CsH₂NCHNH₂PbX₃), and methylammonium tin triiodide (CH₃NH₃SnI₃). These compounds adopt a similar crystal structure to calcium titanium oxide (CaTiO₃) and, when illuminated, generate electron-hole pairs, which can be separated by sandwiching the perovskite absorber layer between an electron transporting n-type layer and a hole-transporting p-type layer, with the perovskite serving as the intrinsic (i) layer so as to form a PIN or NIP junction, analogous to its silicon counterpart.

Such perovskite-based cells can be used as single-junction cells, or can be combined with a silicon cell to create a hybrid tandem PV device, the perovskite junction typically being located on the light-incident side of the cell.

Efficiencies of over 20% have been reported in the literature, such as the 23.6% reported by Bush et al, "23.6%-efficient monolithic perovskite/silicon tandem solar cells with improved stability", Nature Energy 2, Article number: 17009 (2017).

However, such extremely high efficiencies are typically reported for small, lab-based experimental cells, often only 1 cm² in area.

The primary difficulty in commercializing perovskite PV devices lies in their processability on large substrates of the order of over 1 m² used commercially.

The perovskite layer itself is typically deposited in a wet process, such as wet coating followed by evaporation of the carrier solvent, although vapour deposition techniques are also showing promise. An example of room-temperature solution deposition of perovskite is disclosed in Liu & Kelly, "Perovskite solar cells with a planar heterojunction structure prepared using room-temperature solution processing techniques", Nature Photonics 8, 133-138 (2014). This paper reports the use of zinc oxide deposited via a nanoparticle solution for a device in an NIP configuration. However, the use of a solution-based process for depositing zinc oxide is not adapted for large scale commercial production on large substrates, nor for achieving optimal material properties. Furthermore, deposition of such a ZnO or similar layer such as SnOₓ on a non-planar or textured surface such as a surface comprising silicon wafer pyramids is not possible by such a method.

Another issue with the use of perovskites from a processing perspective is their temperature sensitivity, which limits the possibilities for deposing further layers directly or indirectly upon the perovskite material. This process limitation, while of relatively small concern for lab-scale PV devices, becomes significantly problematic when fabricating commercialisable PV devices at the scales required. WO 2018/057419 A1 discloses a solar cell comprising a buffer layer and a CVD process involved in the production of the device. A concrete example shows the forming of a bilayer comprising layers which comprise tin oxide (SnO2) and zinc tin oxide (ZTO), respectively. The layer of tin oxide is formed via ALD deposition using tetrakis(dimethylamino)tin(IV) (TDMASn) and water at approximately 30 °C.

Often, the charge transport layers deposited on the perovskite layer are made from doped organic materials which can be processed without using high temperatures, but which are plagued by serious stability issues. Such solutions are clearly unsuitable for long-term outdoor use in a practical environment. Furthermore, the perovskite itself is extremely moisture-sensitive, and must be extremely well encapsulated.

The aim of the present invention is thus to at least partially overcome the above-mentioned drawbacks of the prior art, and thereby to propose a method of manufacture of a perovskite-based PV device which is susceptible to production on large substrates and exhibits improved long-term stability over the PV devices of the prior art.

### Disclosure of the invention

More specifically, the invention relates to a method of manufacturing a photovoltaic device, comprising the steps of:
- providing a substrate such as glass, metal, polymer, ceramic, a crystalline silicon PV cell, or similar;
- subsequently depositing a first electrode layer on said substrate;
- subsequently depositing a p-type hole transport layer on said electrode;
- subsequently depositing a Perovskite-based absorber layer on said p-type hole transport layer;
- subsequently depositing an n-type electron transport layer on said Perovskite-based absorber layer; and
- subsequently depositing a second electrode layer on said n-type electron transport layer.

Said second electrode layer comprises doped or undoped conductive zinc oxide or tin oxide and is deposited by chemical vapour deposition at an absolute pressure of 5 mbar or less. Temperature during deposition is ideally 160°C or less.

This construction permits depositing zinc oxide or tin oxide as an electrode layer on top of a perovskite layer without damaging the perovskite. Using low pressure CVD in this manner permits high throughput deposition of high quality and extremely uniform ZnO or SnOₓ (i.e. tin oxide with a stoichiometry as desired between SnO and SnO₂) layers on large-area substrates of any shape and surface topography, thereby overcoming the problems of the prior art and enabling large-scale large-size substrate perovskite PV cells which are suitable for being mass-produced.

Advantageously, said n-type electron transport layer comprises a substance based on a Fullerene, such as carbon-60, or a compound based thereupon such as methanofullerene, phenyl-C61-Butyric-Acid-Methyl-Ester, or other similar compound. A composite material comprising a fullerene or fullerene compound is also possible. This may be doped or undoped, and may be combined with another material such as doped or undoped zinc oxide or doped or undoped tin oxide. These materials are compatible with subsequent LPCVD deposition of zinc oxide or tin oxide.

In another variant, the invention relates to a method of manufacturing a photovoltaic device, comprising the steps of:
- providing a substrate such as glass, metal, polymer, ceramic, a crystalline silicon PV cell, or similar;
- subsequently depositing a first electrode layer on said substrate;
- subsequently depositing a p-type hole transport layer on said electrode;
- subsequently depositing a Perovskite-based absorber layer on said p-type hole transport layer;
- subsequently depositing an n-type electron transport layer on said Perovskite-based absorber layer, said n-type electron transport layer being arranged to act as a second electrode layer, and/or as a buffer layer upon which a second electrode layer can be deposited.

Said n-type electron transport layer comprises doped or undoped zinc oxide or tin oxide and is deposited by chemical vapour deposition at an absolute pressure of 5 mbar or less. Temperature during deposition is ideally 160°C or less, and the n-type electron transport layer may also comprise other substances such as a fullerene-based compound (e.g. carbon-60).

Again, this construction permits depositing a zinc oxide or tin oxide layer without damaging the perovskite, and retains the advantages mentioned above. In this configuration, the zinc oxide or tin oxide layer can act as a second electrode layer which simplifies processing, by eliminating a separate electrode layer deposited in a separate step, or can act as a buffer layer. In this latter case, the perovskite is protected by the zinc oxide or tin oxide during subsequent second electrode deposition steps, thereby increasing the number of processes and range of process temperatures which can be used, and the number of materials which can subsequently be deposited as electrode layers or as other layers.

Advantageously, said zinc oxide or tin oxide can be doped with boron to obtain an appropriate conductivity and/or the desired electrical properties of the n-type layer.

Advantageously, a further PIN layer stack is deposited between said substrate and said first electrode, or between said substrate and said p-type hole transport layer. Increased PV device efficiency is thus obtainable with the perovskite-based device of the invention.

Alternatively, the substrate may comprise or may even be constituted by one or more crystalline silicon PV cells comprising one or more PN junctions, the N layer of course being adjacent to the first electrode layer or, if this latter is not present, adjacent to the p-type layer. A tandem PV device with increased efficiency in which the bottom cell is of crystalline silicon is thus created.

Advantageously, said zinc oxide or tin oxide - whether acting only as electrode layer or as a combined n-type and electrode or buffer layer - is deposited with or without any dopants or other substances by chemical vapour deposition under the following process parameters:
- Temperature: 20°C to 160°C;
- Pressure: 0.1 mbar to 5 mbar absolute pressure;
- For zinc oxide: diethyl zinc flow: 50 sccm to 250 sccm, with or without argon (or other) carrier gas;
- For tin oxide: tetramethyl tin flow: 50 sccm to 200 sccm, with or without argon (or other) carrier gas;
- Water vapour flow: 10 sccm to 200 sccm;
- Optionally, boron dopant gas flow: 10 to 100 sccm.

### Brief description of the drawings

Further details of the invention will appear more clearly upon reading the description below, in connection with the following figures which illustrate:
- Figure 1: a schematic representation of a first method of manufacturing a perovskite-based photovoltaic device according to the invention, serving to also illustrate the corresponding PV device in exploded form; and
- Figure 2: a schematic representation of a second method of manufacturing a perovskite-based photovoltaic device according to the invention, serving also to also illustrate the corresponding PV device in exploded form.

### Embodiments of the invention

It should be noted in the following that, unless explicitly stated that a particular layer is deposited directly on the underlying layer, it is possible that one or more intermediate layers can also be present between the layers mentioned. As a result, "on" should be construed by default as meaning "directly or indirectly on". Furthermore, unless specifically stated, layers are not to be presumed as being 100% pure. Contaminants, other components and so on can of course also be present, provided that the layer predominantly retains the properties of the composition mentioned, such as by comprising at least 50% of the substance mentioned. Furthermore, even if not explicitly mentioned, layers can be patterned as required and as is generally known.

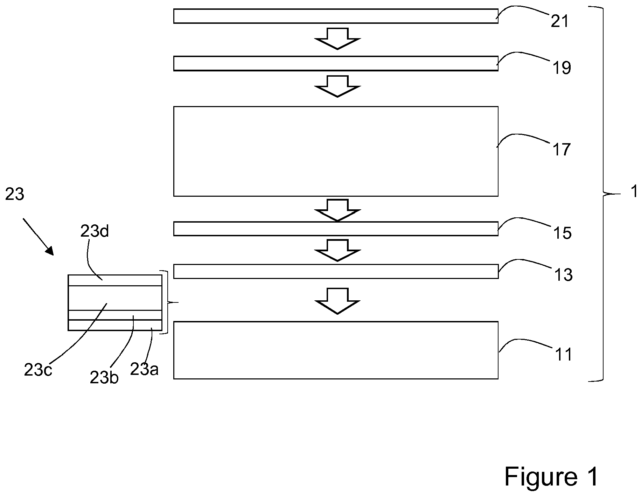

Figure 1 illustrates a first method of manufacturing a photovoltaic (PV) device 1 according to the invention.

Firstly, a substrate 11 is provided. This may be of glass or substantially transparent polymer or other suitable material if the substrate 11 is to be situated on the light-incident side of the PV device 1, or metal, ceramic, polymer, a crystalline silicon PV cell (see below) or other suitable material if the substrate 11 is to be situated on the opposite side to the light-incident side.

A first electrode layer 13 is deposited on the substrate 11, which is typically of transparent conductive oxide (TCO), e.g. doped or undoped zinc oxide, tin oxide, indium tin oxide, fluorine doped tin oxide, titanium oxide, or similar. This may be deposited by any suitable process, such as physical vapour deposition (PVD) with or without plasma enhancement, sputtering, chemical vapour deposition (CVD) with or without plasma enhancement or any other suitable process.

Subsequently, a p-type hole transport layer 15 such as a nickel oxide layer, a molybdenum oxide layer, a tungsten oxide layer or any other suitable layer is deposited on the first electrode layer 13, e.g. by sputtering or any other suitable process. This p-type hole transport layer is appropriately doped if required.

Subsequently, a perovskite layer 17 is deposited on the p-type hole transport layer 15 e.g. by any suitable wet coating or evaporation process.

Once the perovskite layer 17 has formed and any solvent used has fully evaporated, an n-type electron transport layer 19 comprising a material such as a Fullerene (i.e. C₆₀) based material is deposited thereupon, e.g. by an evaporative process. This material may be C60 itself, or a compound based thereupon such as methanofullerene, phenyl-C61-Butyric-Acid-Methyl-Ester, or other similar compound. This may be doped or undoped, and may be combined with another material such as doped or undoped zinc oxide or tin oxide. A composite material comprising a fullerene or fullerene compound is also possible. Also, other n-type layers 19 are possible, provided that their processing is compatible with the underlying perovskite layer.

Subsequently, a second electrode layer 21 is deposited on the electron transport layer 19, so as to form a PIN junction (considered starting from the substrate side). This is formed of zinc oxide (ZnO) or tin oxide (SnOₓ, with any desired stoichiometry between SnO and SnO₂), which may be doped with boron, and is deposited by low pressure CVD (LPCVD) for the following reasons.

In essence, the arrangement of the junction as PIN rather than NIP is the result of a careful choice due to the fact that there are very few p-type materials that can practically be deposited on large size substrates using processes that do not damage the underlying perovskite. In the prior art, for instance in the document US2016/359119, the perovskite junction is NIP, with a zinc oxide N layer deposited on the substrate before the perovskite layer is formed, so as not to damage this latter. The p-layer deposited on the perovskite is an organic p-type material, which is unsatisfactory due to serious concerns about long-term stability and large-scale processability, as mentioned above.

Another document, US2016/126401, uses a zinc oxide layer in a hybrid tandem NIP photovoltaic device, with the zinc oxide being deposited on top of a silicon bottom cell, which can withstand normal ZnO processing parameters. The perovskite is then deposited on top of this zinc oxide, for the same reasons.

Up to now, there has been significant technical prejudice against attempting to deposit zinc oxide or tin oxide on top of perovskite, due to the risks of causing damaging to the heat-sensitive perovskite. However, the inventors have ascertained that, by choosing a PIN rather than NIP construction and using LPCVD to deposit the zinc oxide or tin oxide, this prejudice can be overcome. As a result of the invention, it is thus indeed possible to use zinc oxide or tin oxide on top of perovskite, which will permit not only using a stable material rather than an organic layer, but also using a process which is scalable to produce even-thickness layers even on the largest PV panels.

To do so, LPCVD is carried out under the following process conditions, in the case of a zinc oxide layer:
- Temperature: 20°C to 160°C;
- Pressure: 0.1 mbar to 5 mbar absolute;
- Diethyl zinc flow: 50 sccm to 250 sccm, with or without argon or other carrier gas;
- Water vapour flow: 10 sccm to 200 sccm;
- Optionally, boron dopant gas flow: 10 to 100 sccm.

In the case of LPCVD tin oxide, the process conditions are as follows:
- Temperature: 20°C to 160°C;
- Pressure: 0.1 mbar to 5 mbar absolute;
- Tetramethyl tin flow: 50 sccm to 200 sccm, with or without argon or other carrier gas;
- Water vapour flow: 10 sccm to 200 sccm;
- Optionally, boron dopant gas flow: 10 to 100 sccm.

These processes may be carried out with or without plasma assistance.

Under these parameters, undoped or boron doped zinc oxide, or undoped or boron doped tin oxide (as appropriate), can be deposited on top of a perovskite layer without damaging it e.g. with excessive heat or particle bombardment. Furthermore, LPCVD is capable of deposition rates of zinc oxide or tin oxide (as appropriate) that are compatible with industrial production, unlike another low damage deposition technique such as atomic layer deposition (ALD). It is noted that, technically speaking, ALD could alternatively be used for depositing the zinc oxide or tin oxide since it is compatible with deposition on top of perovskite, but the deposition rate is too low for commercially-viable large-scale production.

Subsequently, any further required layers, encapsulants etc. can be deposited on the PV device thereby obtained.

Although not illustrated explicitly, the PV device may be patterned and may incorporate electrical connections as is generally known in the art so as to form a PV panel.

Figure 1 also schematically illustrates an optional alternative case, namely a tandem PV device 1 in which a silicon-based cell 23 comprising an electrode 23a, a p-type silicon-based layer 23b, an intrinsic silicon-based layer 23c, and an n-type silicon-based layer 23d, is deposited on the substrate 11 before the stack of layers 13, 15, 17, 19 and 21. Naturally, other types of semiconductor other than silicon can be used (e.g. germanium, organic semiconductors and so on), but silicon is mentioned explicitly since it is the dominant technology at the present time. Furthermore, in the case in which an electrode layer between the two PIN junctions is not required, the further PIN layer stack 23 can be deposited between the substrate 11 and the p-type layer 15, in which case electrode layer 13 can be omitted and its role as "first electrode layer" in the sense of the invention is taken over by electrode layer 23a. This hybrid cell hence has a PINPIN configuration.

As a further alternative manner in which to create a tandem cell, the substrate 11 itself may be a crystalline silicon PV cell or cells, manufactured and patterned as normal, and upon which the sequence of other layers 13, 15, 17, 19 and 21 are deposited as mentioned above. In such a case, the PIN junction 23 discussed above is not deposited. This crystalline cell serving as substrate 11 comprises a PN junction comprising a p-type zone and an n-type zone, this latter facing the first electrode layer 13, if present. In such a configuration, the first electrode layer is not essential and can be omitted, with the p-type layer 15 being directly deposited on the n-type zone of the crystalline PV cell in such a case. Again, this creates a tandem hybrid PV device 1, this time in PNPIN configuration, benefitting from the higher efficiency of crystalline silicon cells.

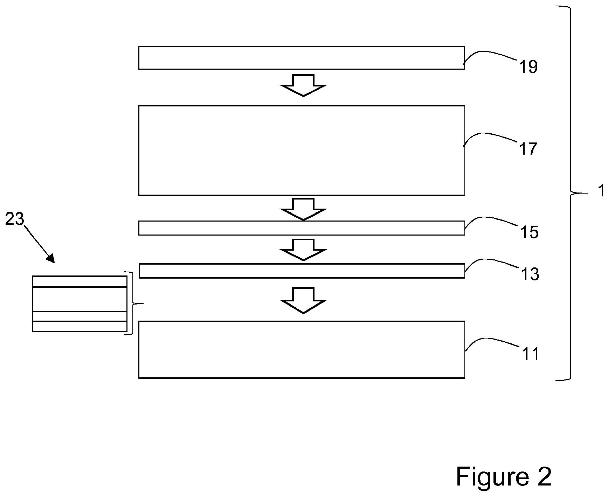

Figure 2 illustrates a variant of a method according to the invention. This method differs from that of figure 1 in that the functional roles of the n-type electron transport layer 19 and the second electrode 21 are combined in a single doped n-type zinc oxide (ZnO) or tin oxide (SnOₓ, as above) layer 19, which is dimensioned and doped so as to give sufficient conductivity that it acts as an electrode. Zinc oxide and tin oxide have the required electronic band alignment with a perovskite intrinsic absorber layer to act as an electron transport layer, which eliminates the need for separate n-type and electrode layers formed of different materials and deposited in separate process steps.

Alternatively, the n-type zinc oxide or tin oxide layer 19 can not only serve as n-type electron transport layer, but can also act as a buffer layer prior to deposition of further layers such as an electrode layer. In this role, the n-type zinc oxide or tin oxide layer serves as electron transport layer and also protects the perovskite from damage due to further deposition steps and/or provides better electrical extraction between the perovskite and the electrode. This increases the variety of processes and materials available for these extra layers (including the electrode layer), since the zinc oxide or tin oxide protects the underlying perovskite layer 17. In such a case, the subsequent electrode layer can comprise materials as mentioned above for the first electrode layer 13, and will resemble the structure of figure 1, with layer 19 comprising zinc oxide or tin oxide and layer 21 comprising a non-zinc-oxide-based electrode layer such as indium tin oxide, fluorine doped tin oxide, titanium oxide, or similar. Again, an optional tandem construction is also possible, with an extra PIN junction 23 being inserted between the substrate 11 and the perovskite-based PIN junction formed by layers 15, 17 and 19, or the substrate 11 itself being a crystalline silicon PV cell comprising a PN junction. The same considerations as discussed above regarding the use of a crystalline silicon PV cell as substrate in the context of figure 1 apply equally in this case.

Not represented on the figures are other known aspects of PV cell construction, such as patterning of the layers, the presence of electrical tracks, metallic electrodes joining individually patterned cells, encapsulant layers, reflector layers, front sheets, rear sheets, light scattering layers, and so on. The skilled person can apply such measures as he sees fit, and it is not required to describe them in detail. Furthermore, various known functional or non-functional intermediate layers can be incorporated as required.

## Claims

1. Method of manufacturing a photovoltaic device (1), comprising the steps of:
- providing a substrate (11);
- depositing a first electrode layer (13) on said substrate (11);
- depositing a p-type hole transport layer (15) on said first electrode layer (13);
- depositing a Perovskite-based absorber layer (17) on said p-type hole transport layer (15);
- depositing an n-type electron transport layer (19) on said Perovskite-based absorber layer (17); and
- depositing a second electrode layer (21) on said n-type electron transport layer (19),
wherein said second electrode layer (21) comprises zinc oxide or tin oxide and is deposited by chemical vapour deposition at an absolute pressure of 5 mbar or less.

2. Method according to claim 1, wherein said n-type electron transport layer (19) comprises a substance based on a Fullerene.

3. Method of manufacturing a photovoltaic device (1), comprising the steps of:
- providing a substrate (11);
- depositing a first electrode layer (13) on said substrate;
- depositing a p-type hole transport layer (15) on said first electrode layer (13);
- depositing a Perovskite-based absorber layer (17) on said p-type hole transport layer (15);
- depositing an n-type electron transport layer (19) on said Perovskite-based absorber layer, said n-type electron transport layer (19) being arranged to act as a second electrode layer and/or as a buffer layer,
wherein said n-type electron transport layer (19) comprises zinc oxide or tin oxide and is deposited by chemical vapour deposition at an absolute pressure of 5 mbar or less.

4. Method according to one of claims 1-3, wherein said zinc oxide or said tin oxide is doped with boron.

5. Method according to one of claims 1-4, wherein a further PIN layer stack (23) is deposited between said substrate (11) and said first electrode (13), or between said substrate (11) and said p-type hole transport layer (15).

6. Method according to one of claims 1-4, wherein said substrate (11) comprises a crystalline silicon photovoltaic cell.

7. Method according to claim 6, wherein said p-type hole transport layer (15) is deposited directly upon an n-type zone of said crystalline silicon photovoltaic cell.

8. Method according to any preceding claim, wherein said zinc oxide or said tin oxide is deposited by chemical vapour deposition under the following process parameters:
• Temperature: 20°C to 160°C;
• Pressure: 0.1 mbar to 5 mbar absolute;
• For zinc oxide: diethyl zinc flow: 50 sccm to 250 sccm, with or without carrier gas;
• For tin oxide: tetramethyl tin flow: 50 sccm to 200 sccm, with or without carrier gas;
• Water vapour flow: 10 sccm to 200 sccm;
• Optionally, boron dopant gas flow: 10 to 100 sccm.

## Patentansprüche

1. Verfahren zur Herstellung einer photovoltaischen Vorrichtung (1), umfassend die Schritte:
- Bereitstellen eines Substrats (11);
- Abscheiden einer ersten Elektrodenschicht (13) auf dem Substrat (11);
- Abscheiden einer Lochleitungsschicht vom p-Typ (15) auf der ersten Elektrodenschicht (13);
- Abscheiden einer Absorberschicht auf Perowskit-Basis (17) auf der Lochleitungsschicht vom p-Typ (15) ;
- Abscheiden einer Elektronenleitungsschicht vom n-Typ (19) auf der Absorberschicht auf Perowskit-Basis (17); und
- Abscheiden einer zweiten Elektrodenschicht (21) auf der Elektronenleitungsschicht vom n-Typ (19);
wobei die zweite Elektrodenschicht (21) Zinkoxid oder Zinnoxid umfasst und durch chemische Gasphasenabscheidung bei einem Absolutdruck von 5 mbar oder weniger abgeschieden wird.

2. Verfahren nach Anspruch 1, wobei die Elektronenleitungsschicht vom n-Typ (19) eine Substanz umfasst, die auf einem Fulleren basiert.

3. Verfahren zur Herstellung einer photovoltaischen Vorrichtung (1), umfassend die Schritte:
- Bereitstellen eines Substrats (11);
- Abscheiden einer ersten Elektrodenschicht (13) auf dem Substrat;
- Abscheiden einer Lochleitungsschicht vom p-Typ (15) auf der ersten Elektrodenschicht (13);
- Abscheiden einer Absorberschicht auf Perowskit-Basis (17) auf der Lochleitungsschicht vom p-Typ (15) ;
- Abscheiden einer Elektronenleitungsschicht vom n-Typ (19) auf der Absorberschicht auf Perowskit-Basis, wobei die Elektronenleitungsschicht vom n-Typ (19) angeordnet ist, um als zweite Elektrodenschicht und/oder als Pufferschicht zu wirken,
wobei die Elektronenleitungsschicht vom n-Typ (19) Zinkoxid oder Zinnoxid umfasst und durch chemische Gasphasenabscheidung bei einem Absolutdruck von 5 mbar oder weniger abgeschieden wird.

4. Verfahren nach einem der Ansprüche 1 bis 3, wobei das Zinkoxid oder das Zinnoxid mit Bor dotiert ist.

5. Verfahren nach einem der Ansprüche 1 bis 4, wobei ein weiterer PIN-Schichtstapel (23) zwischen dem Substrat (11) und der ersten Elektrode (13) oder zwischen dem Substrat (11) und der Lochleitungsschicht vom p-Typ (15) abgeschieden wird.

6. Verfahren nach einem der Ansprüche 1 bis 4, wobei das Substrat (11) eine kristalline Siliciumphotovoltaikzelle umfasst.

7. Verfahren nach Anspruch 6, wobei die Lochleitungsschicht (15) vom p-Typ direkt auf einer Zone vom n-Typ der kristallinen Siliciumphotovoltaikzelle abgeschieden wird.

8. Verfahren nach einem der vorhergehenden Ansprüche, wobei das Zinkoxid oder das Zinnoxid durch chemische Gasphasenabscheidung unter den folgenden Prozessparametern abgeschieden wird:
• Temperatur: 20 °C bis 160 °C;
• Druck: 0,1 mbar bis 5 mbar absolut;
• Für Zinkoxid: Diethylzinkfluss: 50 sccm bis 250 sccm mit oder ohne Trägergas;
• Für Zinnoxid: Tetramethylzinnfluss: 50 sccm bis 200 sccm mit oder ohne Trägergas;
• Wasserdampffluss: 10 sccm bis 200 sccm;
• Gegebenenfalls Bordotiermittelgasfluss: 10 bis 100 sccm.

## Revendications

1. Procédé de fabrication d'un dispositif photovoltaïque (1), comprenant les étapes suivantes :
- obtention d'un substrat (11) ;
- dépôt d'une première couche d'électrode (13) sur ledit substrat (11) ;
- dépôt d'une couche de transport de trous de type p (15) sur ladite première couche d'électrode (13) ;
- dépôt d'une couche d'absorbeur à base de pérovskite (17) sur ladite couche de transport de trous de type p (15) ;
- dépôt d'une couche de transport d'électrons de type n (19) sur ladite couche d'absorbeur à base de pérovskite (17) ; et
- dépôt d'une deuxième couche d'électrode (21) sur ladite couche de transport d'électrons de type n (19),
dans lequel ladite deuxième couche d'électrode (21) comprend de l'oxyde de zinc ou de l'oxyde d'étain et est déposée par dépôt chimique en phase vapeur à une pression absolue de 5 mbar ou moins.

2. Procédé selon la revendication 1, dans lequel ladite couche de transport d'électrons de type n (19) comprend une substance basée sur un fullerène.

3. Procédé de fabrication d'un dispositif photovoltaïque (1), comprenant les étapes suivantes :
- obtention d'un substrat (11) ;
- dépôt d'une première couche d'électrode (13) sur ledit substrat ;
- dépôt d'une couche de transport de trous de type p (15) sur ladite première couche d'électrode (13) ;
- dépôt d'une couche d'absorbeur à base de pérovskite (17) sur ladite couche de transport de trous de type p (15) ;
- dépôt d'une couche de transport d'électrons de type n (19) sur ladite couche d'absorbeur à base de pérovskite, ladite couche de transport d'électrons de type n (19) étant agencée pour agir comme une deuxième couche d'électrode et/ou comme une couche tampon,
dans lequel ladite couche de transport d'électrons de type n (19) comprend de l'oxyde de zinc ou de l'oxyde d'étain et est déposée par dépôt chimique en phase vapeur à une pression absolue de 5 mbar ou moins.

4. Procédé selon une des revendications 1 à 3, dans lequel ledit oxyde de zinc ou ledit oxyde d'étain est dopé avec du bore.

5. Procédé selon une des revendications 1 à 4, dans lequel un autre empilement de couches PIN (23) est déposé entre ledit substrat (11) et ladite première électrode (13), ou entre ledit substrat (11) et ladite couche de transport de trous de type p (15).

6. Procédé selon une des revendications 1 à 4, dans lequel ledit substrat (11) comprend une cellule photovoltaïque en silicium cristallin.

7. Procédé selon la revendication 6, dans lequel ladite couche de transport de trous de type p (15) est déposée directement sur une zone de type n de ladite cellule photovoltaïque en silicium cristallin.

8. Procédé selon une quelconque revendication précédente, dans lequel ledit oxyde de zinc ou ledit oxyde d'étain est déposé par dépôt chimique en phase vapeur avec les paramètres de traitement suivants :
• température : 20 °C à 160 °C ;
• pression : 0,1 mbar à 5 mbar absolus ;
• pour l'oxyde de zinc : débit de diéthylzinc : 50 sccm à 250 sccm, avec ou sans gaz porteur ;
• pour l'oxyde d'étain : débit de tétraméthylétain : 50 sccm à 200 sccm, avec ou sans gaz porteur ;
• débit de vapeur d'eau : 10 sccm à 200 sccm ;
• éventuellement, débit de gaz dopant au bore : 10 à 100 sccm.
